# EUROPEAN PATENT APPLICATION

(11) **EP 2 800 144 A1**
(43) Date of publication of application: **05.11.2014**
(21) Application number: 13166400.5
(22) Date of filing: 03.05.2013
(51) Int. Cl.: H01L 31/0224, H01L 31/0392

(54) **Back contact substrate for a photovoltaic cell or module**

(71) Applicant: Saint-Gobain Glass France, 92400 Courbevoie (FR)
(72) Inventor: Palm, Jörg, 80797 MUNICH (DE); Ruittenberg, Gerard, 52134 Herzogenrath (DE); Urien, Mathieu, 94120 Fontenay sous Bois (FR); Lechner, Robert, 81377 München (DE); Bon Saint Come, Yemina, 75004 Paris (FR)
(74) Representative: Neuviale, Bertrand

(57) **Abstract**

Back contact substrate for a photovoltaic cell, comprising a carrier substrate (2) and an electrode (6), the electrode (6) comprising:
- a conductive coating comprising a metallic thin film (8) based on a metal or metal alloy;
- a barrier to selenization thin film (10) for protecting the conductive coating and based on at least one among MoₓO_{y}N_{z}, WₓO_{y}N_{z}, TaₓO_{y}N_{z}, NbₓO_{y}N_{z}, ReₓO_{y}N_{z}.

## Description

The invention relates to the field of photovoltaic cells, more particularly to the field of non transparent back contact substrates used to manufacture thin film photovoltaic cells.

Specifically, in a known way, some thin film photovoltaic cells, referred to as second generation of photovoltaic devices, use a molybdenum-based back contact substrate coated with a thin light absorbing film (i.e., photoactive material), made of copper (Cu), indium (In), and selenium (Se) and/or sulphur (S) chalcopyrite. It can, for example, be a material of the CulnSe₂ type with a chalcopyrite structure. This type of material is known under the abbreviation CIS. It can also be CIGS, that is to say a material additionally incorporating gallium (Ga), or CIGSSe, that is to say a material incorporating both sulphur and selenium. A second class of materials is made of the Cu₂(Zn,Sn)(S,Se)₄ (i.e. CZTS) type with a Kesterite structure, using zinc and/or tin instead of indium and/or gallium. A third class is made of cadmium telluride (CdTe) and cadmium sulfide (CdS).

For the CIS, CIGS, CIGSSe and the CZTSSe types of applications, the back contact electrodes are generally based on molybdenum (Mo) because this material exhibits a number of advantages. It is a good electrical conductor (relatively low resistivity of the order of 10 µΩ.cm). It can be subjected to the necessary high heat treatments since it has a high melting point (2610°C). It withstands, to a certain extent, selenium and sulphur. The deposition of the thin film of absorbing agent generally requires contact with an atmosphere comprising selenium or sulphur at a high temperature, which tends to damage the majority of metals. Molybdenum reacts with selenium or sulphur, in particular, forming MoSe₂, MoS₂ or Mo(S,Se)₂, but remains conductive and forms an appropriate ohmic contact with the CIS, CIGS, CIGSSe, CZTS or CdTe thin films. Finally, it is a material on which thin films of CIS, CIGS, CIGSSe, CZTS or CdTe types adhere well; the molybdenum even tends to promote the crystal growth thereof.

However, molybdenum exhibits a major disadvantage for industrial production: it is an expensive material. The cost of the raw material is high compared to aluminum or copper. Molybdenum thin films are normally deposited by magnetic-field-assisted cathode sputtering (i.e. magnetron sputtering). As a matter of fact, the manufacturing of molybdenum targets is expensive, too. This is all the more important as, in order to obtain the desired level of electrical conductance (a resistance per square of at most 2 Ω/□ and preferably at most 1 Ω/□, even preferably at most 0.5 Ω/□ after treatment in an atmosphere containing S or Se), a relatively thick thin film of Mo, generally of the order of from 400 nm to 1 micrometer, is necessary.

Patent Application WO-A-02/065554 by Saint-Gobain Glass France teaches the provision of a relatively thin film of molybdenum (less than 500 nm) and the provision of one or more thin films impermeable to alkali metals between the substrate and the molybdenum-based thin film, so as to retain the qualities of the molybdenum-based thin film during the subsequent heat treatments.

Nevertheless, this type of back contact substrate remains relatively expensive.

An object of the present invention is to provide a conductive and corrosion resistant back contact substrate, the manufacturing cost of which is relatively low.

To this end, an aspect of the present invention concerns in particular a back contact substrate for a photovoltaic cell, comprising a carrier substrate and an electrode, the electrode comprising:
a conductive coating comprising a metallic thin film based on a metal or metal alloy;
a barrier to selenization thin film for protecting the conductive coating and based on at least one among MoₓO_{y}N_{z}, WₓO_{y}N_{z}, TaₓO_{y}N_{z}, NbₓO_{y}N_{z}, ReₓO_{y}N_{z}.

Such a back contact substrate exhibits the advantage of making it possible to obtain, with reduced cost materials, a resistance per square equivalent to that of a back contact substrate, the electrode coating of which is composed of just one molybdenum thin film.

By virtue of the back contact substrate, the process for the manufacture of the photovoltaic module is in addition particularly reliable because the barrier to selenization guarantees the presence and a uniform thickness of the main metallic thin film, the conductance properties of which have been retained. The retention of the qualities of the main metallic thin film and the uniformity of the thickness thereof make it possible to reduce the amounts of materials to the minimum.

The barrier to selenization was found to be particularly effective when protecting a metallic thin film based on an alloy, particularly an alloy based on at least one of copper and silver and based also on zinc. It is believed the properties of the barrier to selenization for preventing diffusion of copper and/or silver probably are a reason for its excellent performance. But the invention is not limited to this particular type of metallic thin film.

According to specific embodiments, the back contact substrate comprises one or more of the following characteristics, taken separately or according to all the combinations technically possible:
- the conductive coating is formed on the carrier substrate;
- the barrier to selenization is formed on the conductive coating;
- the barrier to selenization thin film has a compressive stress between 0 and -10GPa, preferably between -1 and -5 GPa;
- the barrier to selenization thin film is nano-crystalline or amorphous with a grain size of at most 10nm;
- the barrier to selenization thin film has a molar composition O/(O+N) of at least 1% and at most 50%, preferably at least 2% and at most 20%;
- the barrier to selenization thin film has a molar composition M'/(M'+O+N) of at least 15% and at most 80%;
- the barrier to selenization thin film has a thickness of at least 5 nm and at most 100nm, preferably at least 10nm and at most 60nm;
- the electrode comprises a second barrier to selenization thin film for protecting the conductive coating and based on at least one among MoₓO_{y}N_{z}, TiₓO_{y}N_{z}, WₓO_{y}N_{z}, TaₓO_{y}N_{z}, NbₓO_{y}N_{z}, ReₓO_{y}N_{z}.
- the conductive coating is formed on the carrier substrate;
- the barrier to selenization is formed on the conductive coating;
- the second barrier to selenization thin film has a compressive stress between 0 and -10GPa, preferably between -1 and -5 GPa;
- the second barrier to selenization thin film is nano-crystalline or amorphous with a grain size of at most 10nm;
- the second barrier to selenization thin film has a molar composition O/(O+N) of at least 1% and at most 50%, preferably at least 2% and at most 20%;
- the second barrier to selenization thin film (10) has a molar M"/(M"+O+N) of at least 15% and at most 80%;
- the second barrier to selenization thin film has a thickness of at least 2 nm and at most 60nm, preferably at least 10nm and at most 40nm;
- said electrode further comprises an interlayer thin film between the conductive coating and the barrier to selenization thin film, the interlayer thin film being based on at least one of titanium (Ti), tungsten (W), molybdenum (Mo), rhenium (Re), niobium (Nb) or tantalum (Ta);
- said interlayer thin film has a thickness of 10nm to 100nm or 20nm to 50nm;
- said electrode further comprises an ohmic contact thin film based on at least a metal M;
- the ohmic contact thin film is formed on the alloy thin film and on the barrier to selenization thin film if present, the ohmic contact thin film is to be contact with the absorber thin film;
- the said metal M is capable of forming a compound of semiconducting sulphide and/or selenide of p type capable of forming an ohmic contact with the photoactive semiconducting material;
- said ohmic contact thin film is based on molybdenum (Mo) and/or tungsten(W);
- the back contact substrate further comprises a barrier to alkali thin film between the carrier substrate and the electrode.
- the barrier thin film is formed on the carrier substrate;
- the barrier to alkali thin film is based on at least one of: silicon nitride, silicon oxide, silicon oxynitride, silicon oxycarbide, aluminum oxide and aluminum oxynitrure;
- the metallic thin film is an alloy thin film based on at least two elements, a first element or several first elements M_{A} chosen among copper (Cu), silver (Ag) and gold (Au), and a second element or several second elements M_{B} chosen among zinc (Zn), titanium (Ti), tin (Sn), silicon (Si), germanium (Ge), zirconium (Zr), hafnium (Hf), carbon (C) and lead (Pb);
- the main metallic thin film is based on:
   at least one of copper (Cu) and silver (Ag); and
   on zinc (Zn).
- the metallic thin film is based on:
   at least one of copper (Cu) and silver (Ag); and
   on zinc (Zn) and titanium (Ti).

Another subject-matter of the invention is a photovoltaic cell comprising a back contact substrate as described above and at least a thin film of a photoactive material.

According to a specific embodiment, said photoactive material is based on chalcogenide compound semiconductors for example a material of Cu(In,Ga)(S,Se)₂ type, in particular CIS,CIGS, CIGSSe or also a material of Cu₂(Zn,Sn)(S,Se)₄ type.

Another subject-matter of the invention is a photovoltaic module comprising several photovoltaic cells formed on the same carrier substrate and electrically connected in series, each photovoltaic cell being as described above.

Another subject- matter of the invention is a process for the manufacture of a back contact substrate for a photovoltaic cell, comprising a step of making an electrode comprising steps of making:
a conductive coating comprising a metallic thin film (8) based on a metal or metal alloy;
a barrier to selenization thin film (10) for protecting the conductive coating and based on at least one among MoₓO_{y}N_{z}, WₓO_{y}N_{z}, TaₓO_{y}N_{z}, NbₓO_{y}N_{z}, ReₓO_{y}N_{z}.

According to specific embodiments, the process exhibits one or more of the following characteristics, taken separately or according to all the combinations technically possible:
- the process comprises a step of formation of a photoactive thin film during which resistivity of the electrode is decreased, and the obtained sheet resistance after thermal annealing is below 2 Ω/□, preferably below 1 Ω/□;
- during said step of formation of a photoactive thin film, having an ohmic contact thin film, said ohmic contact thin film based a metal M is transformed into a sulphide and/or selenide of said metal M.

A better understanding of the invention will be obtained on reading the description which will follow, given solely by way of example and made with reference to the appended drawings, in which:
- Figure 1 is a diagrammatic view in cross section of a conducting substrate;
- Figure 2 is a diagrammatic view in cross section of a solar cell stack;
- Figure 3 are photographs of different back electrodes after a selenization test;
- Figures 4A and 4B are two plots showing a measured mass gain after selenization for different selenization barriers, different thicknesses and different CuₓZn_{y} compositions;
- Figure 5 shows mass gain plots for different sputter depositions conditions, i.e. pressure and ratio of gas (N₂)/(N₂+Ar);
- Figures 6A and 6B shows mass gain and resistance plots for different sputter depositions conditions, i.e. pressure and ratio of gas (N₂)/(N₂+Ar); and
- Figure 7 shows photographs of a series of very thin MoON barriers with different oxygen content.

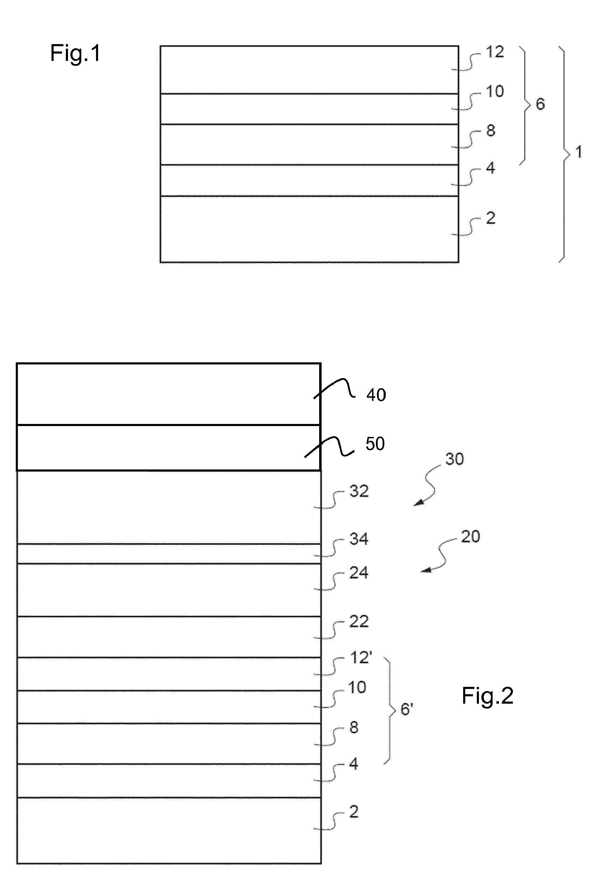

The drawings in Figures 1 and 2 are not to scale, for a clear representation, as the differences in thickness between in particular the carrier substrate and the thin films deposited are significant, for example of the order of a factor of 5000.

Fig.1 illustrates a back contact substrate 1 for a photovoltaic cell comprising:
- a carrier substrate 2 made of glass;
- a barrier to alkali thin film metals 4 formed on the substrate 2; and
- an electrode coating 6 formed on the barrier thin film to alkali metals 4.

Throughout the text, the expression "A formed (or deposited) on B" is understood to mean A is formed either directly on B and thus in contact with B or formed on B with interposition of one or more thin films between A and B.

It should be noted that, throughout the text, the term "electrode" is understood to mean an electrical current transport coating comprising at least one thin film which conducts electrons, that is to say having a conductivity which is provided by the mobility of electrons.

It should also be noted that, throughout the text, it is hereby meant by "a material based on A" that the material is mainly made of A, so that its aimed function is fulfilled. It preferably contains at least 80% atomic percent of A, for example at least 90% atomic percent of A. If the material is "based on A and B", it is meant that it preferably contains at least 80% total atomic percent of A and B, for example at least 90% total atomic percent of A and B.

It is meant by "total atomic content" that the atomic contents of the elements are added. If the atomic content of A is 35% and the atomic content of B is 55%, the total atomic content of A and B is 90%.

In addition, throughout the text, the expression "comprises a thin film" should, of course, be understood as "comprises at least one thin film".

The barrier to alkali thin film 4 is, for example, based on one of: silicon nitride, silicon oxide, silicon oxynitride, silicon oxycarbide, aluminum oxide or aluminum oxynitride, as will be further explained below.

The electrode coating 6 illustrated is composed of:
- a metallic thin film 8 formed directly on the barrier to alkali thin film 4;
- a barrier to selenization thin film 10 formed directly on the metallic thin film 8; and
- an ohmic contact thin film 12 based on a metal M and formed directly on the barrier to selenization thin film 10.

The metallic thin film 8 forms a main conductive coating of the electrode. It is essential for achieving the required conductance for the electrode 6 and will be further explained in detail below. The main conductive coating may comprise only one thin film or several thin films, for example several metallic thin films.

It should be noted that, throughout the text, the term "only one thin film" is understood to mean a thin film of one and the same material. This single thin film can nevertheless be obtained by the superposition of several thin films of one and the same material, between which exists an interface which it is possible to characterize, as described in WO-A-2009/080931.

The barrier to selenization 10 protects the metallic thin film 8 from selenization. Importantly, the barrier to selenization thin film 10 is based on at least one among MoxOyNz, WxOyNz, TaxOyNz, NbxOyNz, RexOyNz.

The ohmic contact thin film 12 is for establishing a good electrical contact with the light absorbing chalogenide thin film to be deposited directly above. It is, for example, based on elemental molybdenum or elemental tungsten.

The barrier to selenization 10 and the ohmic contact thin film 12 will be further explained below.

Such a back contact substrate 1 is intended for the manufacture of a photoactive material with addition of sodium. This element is known to improve the performance of photoactive materials of CIS, CIGS or CIGSSe type. As the sodium content is a key parameter in the process, the sodium migration from the glass towards the photoactive material needs to be controlled and so, the presence of an alkali barrier film 4 can be needed. In the case where the substrate does not comprise alkali species or as impurity, the barrier to alkali thin film 4 can be omitted. By "alkali", it is meant "alkali element" whatever its oxidation state, i.e. in metallic or ionic form. A typical glass substrate is for example, a soda-lime-silica glass and comprises sodium ions.

Another technique for the manufacture of the photoactive material consists in using the migration of the sodium ions from the carrier substrate, for example made of glass, in order to form the photoactive material. In this case, the back contact substrate 1 does not have a barrier to alkali thin film 4 and the alloy thin film 8 is, for example, formed directly on the carrier substrate 2.

In an alternative form also, the electrode 6 comprises one or more inserted thin films.

Thus, the back contact substrate 1 comprises a carrier substrate 2 and an electrode 6 comprising:
- a conductive coating comprising a metallic thin film 8 formed on the carrier substrate 2;
- a barrier to selenization 10 formed on the metallic thin film 8, for protecting the conductive coating, i.e. the metallic thin film, and based on M'ₓN_{y}O where M' is chosen among Mo, W, Ta, Nb or Re at least one among on at least one among MoₓO_{y}N_{z}, WₓO_{y}N_{z}, TaₓO_{y}N_{z}, NbₓO_{y}N_{z}, ReₓO_{y}N_{z}; and
- an ohmic contact thin film 12 based on a metal M and formed on the barrier to selenization thin film 10.

For CIS, CIGS and CIGSSe, having an ohmic contact thin film 12 for example based on molybdenum is preferred, but other chalcogenide semiconductors like AglnS₂, CZTS or CdTe may function well if deposited directly on the alloy thin film 8. Thus, in an alternative form, the electrode 6 does not comprise the ohmic contact thin film. In this case, the barrier to selenization thin film 10 needs to form a good ohmic contact to the light absorbing thin chalogenide film.

Thus, more generally, the back contact substrate 1 comprises a carrier substrate 2 and an electrode coating 6 comprising:
- a metallic thin film formed on the carrier substrate 2;
- a barrier to selenization 10 for protecting the conductive coating, i.e. the metallic thin film, and based on at least one among MoₓO_{y}N_{z}, WₓO_{y}N_{z}, TaₓO_{y}N_{z}, NbₓO_{y}N_{z}, ReₓO_{y}N_{z}.

### Barrier to selenization thin film

It was found that such a barrier to selenization 10 was very effective for protecting the metallic thin film from possible selenization and/or sulphurization. It should be noted that a thin film which protects from selenization also protects from sulphurization.

It was also found that such a barrier to selenization was particularly suitable for protecting an alloy thin film 8 based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb), more particularly for protecting an alloy thin film based on at least one of copper (Cu) and silver (Ag) and on zinc (Zn), optionally further based on titanium (Ti).

The barrier to selenization thin film 10 further protects the alloy thin film 8 from possible selenization and/or sulphurization. It should be noted that a thin film which protects from selenization also protects from sulphurization.

The term "barrier thin film to selenization" is understood to mean a thin film of a material of any type capable of preventing or reducing the selenization of thin films covered with the barrier to selenization during the deposition, on the barrier to selenization, of thin films of semiconducting materials formed by selenization and/or sulphurization. The barrier to selenization within the meaning of the invention shows a proven effectiveness even at a thickness of 3 nm.

A possible selenization test for determining if a material is suitable or not for a role as barrier to selenization is to compare a sample with and without a thin film of 5 nm of this material between the ohmic contact thin film 12 and the alloy thin film 8 and to subject the samples to a selenization, for example by heating at 520°C in a 100% selenium atmosphere at atmospheric pressure during 10 minutes. If the selenization of the alloy thin film 8 is reduced or prevented and the ohmic contact thin film 12 is entirely selenized, the material is effective.

The material of the barrier to selenization thin film 10 is importantly based on at least one among MoₓO_{y}N_{z}, WₓO_{y}N_{z}, TaₓO_{y}N_{z}, NbₓO_{y}N_{z}, ReₓO_{y}N_{z}.

It is preferably based on MoₓO_{y}N_{z}, optionally further comprising any of the above cited metal oxynitrides. For example, the barrier selenization is preferably made of pure MoₓO_{y}N_{z}, but it may be made of a mix of several oxynitrides at long at it contains one the claimed oxynitrides, for example
α at% of MoₓO_{y}N_{z} + (100- α) at% of [WₓO_{y}N_{z}, TaₓO_{y}N_{z}, NbₓO_{y}N_{z}, ReₓO_{y}N_{z}, TiₓO_{y}N_{z}, etc.], with α between 1 and 99, or any other possible mixture.

However, for sake of simplicity, it is preferably based on only one among MoₓO_{y}N_{z}, WₓO_{y}N_{z}, TaₓO_{y}N_{z}, NbₓO_{y}N_{z}, ReₓO_{y}N_{z}, preferably made of only one among MoₓO_{y}N_{z}, WₓO_{y}N_{z}, TaₓO_{y}N_{z}, NbₓO_{y}N_{z}, ReₓO_{y}N_{z}.

It should be noted that the above oxynitrides can be substoichiometric, stoichiometric or superstoichiometric respectively in nitrogen and oxygen.

The barrier to selenization thin film 10 preferably has a compressive stress between 0 and -10GPa, more preferably between -1 and -5 GPa.

Preferably also, the barrier to selenization thin film 10 is nano-crystalline or amorphous with a grain size of at most 10nm.

Preferably, the barrier to selenization 10 has a molar composition O/(O+N) of at least 1 % and at most 30% It has been observed that the addition of oxygen decreases crystallinity of the metal oxynitride film.

Preferably also, the barrier to selenization thin film 10 has a molar composition M'/(M'+O+N) of at least 15% and at most 80.

If the barrier thin film to selenization 10 is very thin, there is a risk of it no longer having a significant effect. It thus has, for example, a thickness of at least 5 nm, preferably of at least 10 nm. Surprisingly, it turned out that a barrier thin film to selenization 10 having so slight a thickness had a significant effect.

The barrier to selenization thin film 10 has a lower conductivity than the main metallic thin film 8. For example, it has a resistivity of between 20 µohm.cm and 1000 µohm.cm.

If the barrier to selenization thin film is too thick, the resistance through its thickness will be increased. Preferably, the barrier to selenization thin film 10 has a thickness of at most 100nm, preferably at most 50nm. The thickness also has a significant impact on the materials and manufacturing cost. The proper selection of barrier properties will guarantee that the thickness can be strongly reduced without losing the required resistance against selenization and sulphurization.

As a result of the slight thickness of the barrier to selenization thin film 10, a high resistivity is not harmful to the performance of the cell, the electrical current passing transversely.

The barrier to selenization thin film also improves the adhesion between the upper layers, .i.e. the photoactive thin film such as the CIS, CIGS, CIGSSe and the Mo(S,Se)₂ ohmic contact thin film, with the lower layers i.e. the metal or metal alloy thin film(s).

The barrier to selenization thin film 10 is, in addition, preferably capable of limiting the backward diffusion of the sodium ions towards the carrier substrate 2, that is to say the diffusion of the sodium ions from the top of the upper thin film 12 through the upper thin film 12 and towards the carrier substrate 2.

This property is advantageous in several respects.

The manufacturing processes that use intentional sodium dosing will be more reliable. A controlled sodium doping can be achieved by adding alkali metals in order to form the photoactive material, for example by deposition of a sodium compound on the electrode 6 or by addition of sodium during the deposition of the photoactive material, for example using targets comprising sodium or other alkali metals, as described in US-B-5 626 688.

The electrode 6 described above comprises only one barrier to selenization 10.

In an alternative embodiment, the electrode comprises a second barrier to selenization thin film (not shown).

The second barrier to selenization preferably has the same characteristics as the barrier to selenization thin film 10 described above. However, this second barrier to selenization may also be based on TiₓO_{y}N_{z}.

It is also formed on the metallic thin film 8 for protecting it. It may be formed on the first barrier to selenization thin film 10 or between the metallic thin film 8 and the first barrier to selenization thin film 10.

As mentioned above, the second barrier to selenization thin film is based on at least one among MoₓO_{y}N_{z}, TiₓO_{y}N_{z}, WₓO_{y}N_{z}, TaₓO_{y}N_{z}, NbₓO_{y}N_{z}, ReₓO_{y}N_{z}.

It is preferably based on TiₓO_{y}N_{z}, optionally further comprising any of the above cited metal oxynitrides. For example, the barrier selenization is preferably made of TiₓO_{y}N_{z}, but it may be made of

α at% TiₓO_{y}N_{z} (100-α) at% [MoₓO_{y}N_{z}, WₓO_{y}N_{z}, TaₓO_{y}N_{z}, NbₓO_{y}N_{z}, ReₓO_{y}N_{z}] with α between 1 and 99, or

α at% TiₓO_{y}N_{z} (100-α) at% MoₓO_{y}N_{z} with α between 1 and 99 or any other possible mixture. However, for sake of simplicity, it is preferably based on only one among TiₓO_{y}N_{z}, MoₓO_{y}N_{z}, WₓO_{y}N_{z}, TaₓO_{y}N_{z}, NbₓO_{y}N_{z}, ReₓO_{y}N_{z}, preferably made of only one among TiₓO_{y}N_{z}, MoₓO_{y}N_{z}, WₓO_{y}N_{z}, TaₓO_{y}N_{z}, NbₓO_{y}N_{z}, ReₓO_{y}N_{z}.

It should be noted that the above oxynitrides can be substoichiometric, stoichiometric or superstoichiometric respectively in nitrogen and oxygen.

The second barrier to selenization thin film preferably has a compressive stress between 0 and -10GPa, more preferably between -1 and -5 GPa. Preferably also, the second barrier to selenization thin film is nano-crystalline or amorphous with a grain size of at most 10nm. Preferably, the second barrier to selenization thin film 10 has a molar composition O/(O+N) of at least 1 % and at most 30% It has been observed that the addition of oxygen decreases crystallinity of the metal oxynitride film.

Preferably also, the second barrier to selenization thin film has a molar composition M'/(M'+O+N) of at least 15% and at most 80.

Due to the presence of two barriers to selenization, each barrier to selenization thin film preferably has a thickness of at least 2 nm and at most 40nm, preferably at least 10nm and at most 50nm.

### Metallic thin film

The metallic thin film 8 will now be described in more detail.

In a first possible embodiment, the metallic thin film 8 is for example based on molybdenum, silver (Ag), or copper (Cu) with a content of at least 95% of one of the preceding elements. More generally, it is made of a metal element with a content of at least 95% of this element.

In another embodiment of the invention, the metallic thin film 8 is based on an alloy, preferably an alloy based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

In other words also, the alloy thin film 8 is based on at least two elements, at least one first element M_{A} chosen among group (Ib) of the periodic table, and at least one second element M_{B} chosen among zinc (Zn), group (IVa) and group (IVb) of the periodic table.

Preferably, the metallic thin film is based:
- on at least one among copper (Cu) and silver (Ag); and
- on zinc (Zn).

It should first be noted that the term "alloy" is meant to mean a mixture of either pure or fairly pure chemical elements (at least one of which being a metal) which forms an impure substance (admixture) that retains the characteristics of a metal. An alloy may not necessarily be a perfectly uniform mix of the atoms of the elements or be perfectly pure. It may be formed, for example, by depositing a thin film of a first element or alloy, subsequent depositing of a thin film of a second element or alloy, followed by a thermal annealing step making an alloy of the first and second elements or alloys. The sequence element/alloy or element1/element2, or alloy1/alloy2 can be repeated several times (element/alloy/element/alloy.....)

But, after a thermal annealing treatment or before, the alloy thin film is based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

There may be one or several first elements M_{A} and one or several second elements M_{B}.

The alloy thin film may for example be based on:
- only one first element M_{A} and only one second element M_{B} (e.g. CuZn),
- only one first element M_{A} and several second elements M_{B} (e.g. CuZnTi),
- on several first elements M_{A} and only one second element M_{B} (e.g. CuAgZn),
- or several first elements M_{A} and several second elements M_{B} (e.g. CuAgZnTi),

An advantage of such an alloy is its lower resistivity compared to molybdenum, its lower cost and its capability to maintain or reduce its resistivity during the solar cell process in the presence of heat and corrosive elements such as sulphur, selenium or tellurium. The product of resistivity * density is also much lower. Table I shows the properties of the preferred elements.

**Table I Melting point, conductivity and density for each preferred material.**

| | melt ing point | Conductivit y | density | P eriodic Group |
|---|---|---|---|---|
| Titanium (Ti) | 1668 °C | 2.5 · 10⁶ A/(V·m) | 4.5 g/cm³ | **M (IVb)** |
| Zirkoniu m (Zr) | 185 7 °C | 2.36 · 10⁶ A/(V·m | 6.5 g/cm³ | **M (IVb)** |
| Tin (Sn) | 231 .9 °C | 8.69 · 10⁶ A/(V·m) | 5.77 g/cm³ (α-Zinn) | **M (IVa)** |
| | | | 7.26 g/cm³ (ß-Zinn) | |
| Zinc (Zn) | 419 .5 °C | 16,6×10⁶ A/(V·m) | 7.14 g/cm³ | **M (IIb)** |
| Copper (Cu) | 108 4.6°C | 59.1 · 10⁶ A/(V·m | 8.92 g/cm³ | **M (Ib)** |
| Silver (Ag) | 961 .8°C | 61.4 · 10⁶ A/(Vm)· | 10.49 g/cm³ | **M (Ib)** |

Copper (Cu) and silver (Ag) are preferred for the first(s) element(s)M_{A}.

Zinc (Zn), titanium (Ti), tin (Sn) and Zirconium (Zr) are preferred for the second(s) element(s) M_{B}.

The resistivity of M_{A} and M_{B} alloys also depends significantly on the M_{B} atomic content in the alloy and on the prevailing alloy phase or composition of alloy phases.

The function of the alloy thin film 8 is conducting the electrical current of the solar cell. A key requirement is its corrosion resistance to sulfur and selenium. Depending on the process, the alloy thin film may need to withstand temperatures up to 600°C.

The alloy thin film 8 may contain one or more of the following additional elements: titanium, (Ti), aluminum (AI), molybdenum (Mo), manganese (Mn), vanadium (V), silicon (Si), arsenic (As), oxygen (O) or nitrogen (N) with a total maximum atomic content below5%

The alloy thin film 8 has preferably a thickness between 30nm and 300nm, more preferably between 50nm and 150nm.

The alloy thin film 8 has a sufficient thickness for the electrode 6 and the alloy thin film 8 to have, after a selenization test as described above, a resistance per square of less than or equal to 2 Ω/□, preferably of less than or equal to 1 Ω/□. The presence of the upper thin film 12 based on the metal M and of the barrier to selenization thin film 10 makes it easier to achieve such performances.

### Ohmic contact thin film

The metal M used for the ohmic contact thin film 12, is capable of forming, after sulphurization and/or selenization, an ohmic contact thin film with a photoactive semiconducting material, in particular with a photoactive semiconducting material based on copper and selenium and/or sulphur chalcopyrite, for example a photoactive material of Cu(In,Ga)(S,Se)₂ type, in particular CIS or CIGS, CIGSSe, or also a material of Cu₂(Zn,Sn)(S,Se)₄ type or a material of cadmium telluride (CdTe) or cadmium sulphide (CdS) types.

The term "an ohmic contact thin film" is understood to mean a thin film of a material such that the current/voltage characteristic of the contact is non-rectifying and linear.

Preferably, the ohmic contact thin film 12 is the final ohmic contact thin film of the electrode 6, that is to say that the electrode 6 does not have another thin film above the thin film 12.

The thin film 12 is intended to be fully transformed, by selenization and/or sulphurization, into Mo(S,Se)₂, which material is not, on the other hand, regarded as a material "based on elemental molybedenum" but a material based on molybdenum disulphide, on molybdenum diselenide or on a mixture of molybdenum disulphide and diselenide.

Conventionally, the notation (S,Se) indicates that this concerns a combination of SₓSe₁₋ₓ with 0 ≤ *χ* ≤ 1.

It should be noted that the substrate illustrated in Figure 1 and described above is an intermediate product in the manufacture of a photovoltaic cell or module. This intermediate product is subsequently transformed as a result of the process for the manufacture of the photoactive material. The back contact substrate 1 described above is understood as the intermediate product before transformation, which can be stored and dispatched to other production sites for the manufacture of the module.

The ohmic contact thin film 12, so as to act as ohmic contact once transformed into Mo(S,Se)₂, for example has a thickness of at least 10 nm and at most 100 nm before selenization, preferably of at least 30 nm and at most 50 nm. A large thickness is not necessary. After selenization, Mo(S,Se)₂ has a thickness which is 3-4 times the thickness of the initial molybdenum thin film.

The said metal M is advantageously molybdenum-based and/or tungsten-based.

The molybdenum disulphide and/or diselenide compounds Mo(S,Se)₂ are materials having a proven effectiveness as ohmic contact thin film. Tungsten (W) is a material with similar chemical properties. It also forms chalcogenide semiconductors WS₂ and WSe₂. Mo(S,Se)₂ and W(S,Se)₂ can both be formed as p type semiconductors. More generally still, it concerns a metal M of any type capable of forming, after sulphurization and/or selenization, an ohmic contact thin film with a photoactive semiconducting material, more particularly with a photoactive material based on copper and selenium and/or sulphur chalcopyrite.

### Interlayer

The possible interlayer thin films between the alloy thin film 8 and the barrier to selenization thin film 10 will now be described.

The interlayer thin film is preferably metallic and based on at least one of the refractory elements titanium (Ti), tungsten (W), molybdenum (Mo), rhenium (Re), niobium (Nb) or tantalum (Ta). Concerning titanium (Ti), it should be noted that if the titanium (Ti) thin film is thick or the process at a relatively low temperature, titanium is not totally consumed in the alloy and there might remain a residual thickness of titanium. These metals have very high melting points. They are corrosion resistant and can further increase the protection of the alloy thin film against sulfur and selenium. In addition, these metals show a very high hardness. Both physical properties are advantageous for the patterning and cell definition processes that are typically used for the manufacturing of thin film solar modules. In these processes, some thin films of the solar cell may have to be selectively removed without damaging the other thin films: in P1 scribing, the back electrode made of the alloy thin film and optional barrier to selenization thin film and ohmic contact thin film need to be cut without destroying the alkali barrier thin film, in P2 scribing, the absorber thin film needs to be cut without damaging the back electrode and in P3 scribing, the transparent conducting oxide needs with or without the absorber thin film to be cut without damage to the back electrode stack. These selective thin film removal processes can be made by laser processes (P1,P2,P3) or mechanical processes (P2,P3). In both cases the interlayer thin film will protect the conducting alloy thin film 8 due to its hardness and high melting point.

### Carrier substrate

The carrier substrate 2 and the barrier to alkali 4 will now be described. The carrier substrate can be rigid or flexible and can be made of a variety of materials such as soda-lime-silica or borosilicate glass, ceramic sheets, metal films, or polymer films.

Two cases may be distinguished: the case where alkali are added on the back contact substrate during or before the formation of the absorber thin film (first case) and the case where only migration of alkali from the carrier substrate is used for doping the absorber layer (second case).

The substrates provided with one or more barrier to alkali thin films 4 (i.e. a barrier to the diffusion of alkali species) are used in the first case, in particular in order to make it possible to use, as substrate, a sheet of glass of soda-lime-silica type obtained by the float process, glass of relatively low cost which exhibits all the qualities which are known in this type of material, such as, for example, its transparency, its impermeability to water and its hardness.

The content of alkali species of the substrate 2 is, in this case, a disadvantage which the barrier to alkali thin film 4 will minimize, since only alkali from the addition on the back contact substrate and in a controlled amount are wanted.

The barrier to alkali 4 is preferably based on at least one of the materials chosen from: silicon nitride, silicon oxide, silicon oxynitride, silicon oxycarbide, a mix of silicon oxycarbide and silicon oxynitride, aluminum oxide or aluminum oxynitride.

Alternatively, a soda-lime-silica glass substrate is used without a barrier to alkali thin film but the alkali mobility is reduced by a matrix adaptation to benefit of the so-called mixed-alkali effect. The sodium content that may diffuse through the electrode to dope the photoactive material is significantly reduced and alkali are added during or before formation of the absorber thin film.

In an alternative form, still in the first case, the carrier substrate 2 is a sheet of a material of any appropriate type not comprising alkali species, for example a silica-based glass not comprising alkali species such as borosilicate glasses, high-strain point glass or made of plastic, or even of metal.

In the second case (no addition of alkali), the carrier substrate 2 is of any appropriate type comprising alkali species, for example comprising sodium ions and potassium ions.

The substrate is, for example, a soda-lime-silica glass. The barrier to alkali thin film is absent.

In both cases, the carrier substrate 2 is intended to act as back contact in the photovoltaic module once the electrode is formed on it and thus does not need to be transparent. The sheet constituting the carrier substrate 2 can be flat or rounded, and can exhibit dimensions of any type, in particular at least one dimension of greater than 1 meter.

### Manufacturing Process

Another subject-matter of the invention is a process for the manufacture of the back contact substrate 1 described above.

The process comprises the stages consisting in:
- depositing the alloy thin film 8 on the carrier substrate 2, with optional prior deposition of the barrier to alkali thin film 4 and /or optional prior deposition of the adhesion thin film;
- depositing the optional barrier to selenization thin film 10 on the alloy thin film 8, for example directly on it or with interposition of an intermediate thin film;
- depositing the optional ohmic contact thin film 12 based on the metal M on the barrier to selenization thin film 10, in which case transforming the said thin film based on metal M into a sulphide and/or selenide of the metal M. This transformation stage can be a separate stage before the formation of the CIS, CIGS or CZTS semiconducting thin film or a stage carried out during the selenization and/or sulphurization of the CIS, CGS or CZTS semiconducting thin film, whether this selenization and/or sulphurization is carried out during the deposition of the said semiconducting thin film or after deposition of metal components said to be precursors of the semiconducting thin film.

In the course of the industrialization of the sputtering process of CuZn-thin films or AgZn or AgCuZn, the deposition of multilayer elemental stacks instead of alloyed thin films is a possible alternative. Especially in this case, deviations from the targeted alloy phase should be expected for the alloy thin film. An extreme case would be a multilayer stack of elemental Cu and elemental Zn or a multilayer stack of elemental silver and zinc or alternating thin films of elemental Cu, elemental silver and elemental zinc.. After thermal processing of the CIGSSe thin film on this substrate, the phase transformation into more desirable CuZn or AgZn or CuAgZn phases is achieved. This circumstance, however, has significant impact on production monitoring and process control.

Typically, in a magnetron sputtering deposition chamber, several thin films of one and the same material will be successively formed on the carrier substrate by several targets in order to form, after thermal annealing, just one thin film of one and the same material.

For example, in the case of CuZn
- successive metal thin films Cu/Zn or Zn/Cu
- 1 metal thin film/1 alloy rich in Zn thin film: Cu/CuZn_{rich}/Cu
- 1 metal thin film/1 alloy poor in Znthin film: Zn/CuZₚₒₒᵣ/Zn
- 2 alloys CuZn_{richthin film}/CuZnₚₒₒᵣthin film or CuZnₚₒₒᵣ/CuZn_{rich}
or any combination thereof. This example can be transposed to any alloy mentioned here above.

This is why according to an embodiment of the invention, the process of forming the alloy thin film comprises the steps of;
- forming a thin film containing at least one of the first element(s) M_{A}; and
- forming another thin film of a different material and containing at least one of the second element(s) M_{B}.

The deposition of the various thin films is, for example, carried out by magnetron cathode sputtering but, in an alternative form, another process of any appropriate type is used, e.g. thermal evaporation, chemical vapor deposition or electrochemical deposition.

### Photovoltaic Cell

Another subject-matter of the invention is a semiconductor device 20 (Fig. 2) which uses the back contact substrate 1 described above to form one or more photoactive thin films 22, 24 thereon.

The first photoactive thin film 22 is typically a doped thin film of p type, for example based on copper Cu, indium In, and selenium Se and/or sulphur S chalcopyrite. It can be, for example, as explained above, CIS, CIGS, CIGSSe or CZTS.

The second photoactive thin film 24 is doped, of n type and described as buffer. It is, for example, composed of CdS (cadmium sulphide) and is formed directly on the first photoactive thin film 22.

In an alternative form, the buffer thin film 24 is, for example, based on InₓS_{y}, Zn(O,S) or ZnMgO or is made of another material of any appropriate type. In an alternative form again, the cell does not comprise a buffer thin film and the first photoactive thin film 22 itself forms a p-n homojunction.

Generally, the first photoactive thin film 22 is a thin film of p type or having a p-n homojunction obtained by addition of alkali metal elements.

The deposition of the photoactive thin film comprises stages of selenization and/or sulphurization, as explained in more detail below. The deposition can be carried out by evaporation of the elements Cu, In, Ga and Se (or Cu, Sn, Zn, S). During these selenization and/or sulphurization stages, the ohmic contact thin film 12 based on the metal M is transformed into a thin film 12' based on M(S,Se)₂. This transformation concerns, for example, the whole of the ohmic contact thin film 12.

The semiconducting device 20 thus comprises the carrier substrate 2 and the electrode 6' formed on the carrier substrate 2, the ohmic contact thin film 12' of which has been transformed.

The electrode 6' comprises:
- the alloy thin film 8;
- the optional barrier to selenization thin film 10 formed on the alloy thin film 8; and
- the optional ohmic contact thin film 12', based on M(S,Se)₂, formed on the barrier to selenization 10. The semiconducting device comprises, on the ohmic contact thin film 12' and in contact with the latter, the photoactive semiconducting thin film(s) 14, 16.

Another subject-matter of the invention is a photovoltaic cell 30 comprising a semiconducting device 20 as described above.

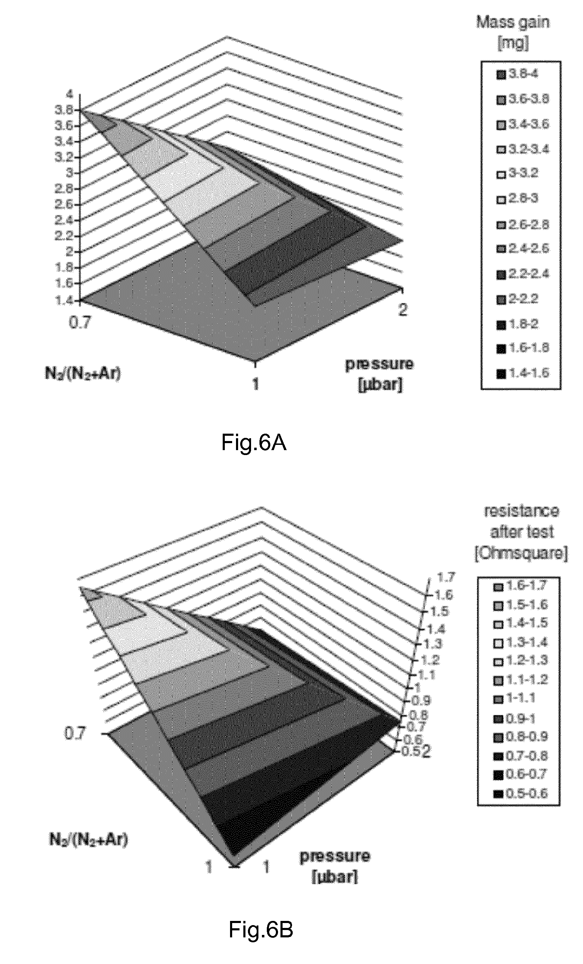

The cell comprises, for example, as illustrated in Figure 6:
- the semiconducting device 20 formed by the thin films 8, 10, 12', 22 and 24;
- a transparent electrode 32, for example made of ZnO:Al, formed on the first photoactive thin film 22 and on the buffer thin film 24, in the event of the presence of the latter, with optional interposition, between the transparent electrode 32 and the semiconducting device 20, of a resistive thin film 34, for example of intrinsic ZnO or of intrinsic ZnMgO.

The transparent electrode 32 comprises, in an alternative form, a thin film of zinc oxide doped with gallium or boron, or also an indium tin oxide (ITO) thin film.

Generally, it is a transparent conducting material (TCO) of any appropriate type.

The transparent electrode 32 is the so-called front electrode. As a reminder, in a photovoltaic cell or module, the back electrode 6 is the electrode placed after the absorber thin film on the path of incoming light and the front electrode the one placed before. This is why a carrier substrate 2 with a back electrode 6 deposited on it is called a back contact substrate.

For a good electrical connection and good conductance, a metal grid (not represented in Figure 2) is subsequently optionally deposited on the transparent electrode 32, for example through a mask, for example by an electron beam. It is, for example, an Al (aluminum) grid, for example with a thickness of approximately 2 µm, on which is deposited a Ni (nickel) grid, for example with a thickness of approximately 50 nm, in order to protect the Al thin film.

The cell 30 is subsequently protected from external attacks. It comprises, for example, to this end, a counter-substrate 40covering the front electrode 32 and laminated to the coated substrate, i.e. to the front electrode 32, via a lamination foil 50 made of a thermoplastic polymer. It is, for example, a sheet of EVA, PU or PVB.

Another subject-matter of the invention is a photovoltaic module comprising several photovoltaic cells formed on the same substrate 2, which cells are connected to one another in series and are obtained by subsequent patterning and coating of the thin films of the semiconducting device 20. This monolithic integration of up to 100 individual cells is the state of the art for large area commercial thin film modules. It also includes the making of one to more than 100 laser P1 scribing trenches through the ohmic contact thin film 12, the barrier to selenization thin film 10 and the alloy thin film 8.

Another subject-matter of the invention is a process for the manufacture of the semiconducting device 20 and of the photovoltaic cell 30 above, which process comprises a stage of formation of a photoactive thin film by selenization and/or sulphurization.

Numerous known processes exist for the manufacture of a photoactive thin film of Cu(In,Ga)(S,Se)₂ type. The photoactive thin film 22 is, for example, a CIGS or CIGSSe thin film formed in the following way.

In a first stage, the precursors of the thin film are deposited on the electrode 6.

A metal stack composed of an alternation of thin films of CuGa and In type is, for example, deposited on the electrode 6 by magnetron cathode sputtering at ambient temperature. A thin film of selenium is subsequently deposited at ambient temperature directly on the metal stack, for example by thermal evaporation.

In an alternative form, the metal stack has, for example, a multilayer structure of Cu/In/Ga/Cu/In/Ga... type.

In a second stage, the substrate is subjected to a heating treatment at high temperature, referred to as RTP ("Rapid Thermal Process"), for example at approximately 520°C, in an atmosphere composed, for example, of gaseous sulphur, for example based on S or H₂S, thus forming a thin film of CuInₓGa₁₋ₓ(S,Se)₂.

One advantage of this process is that it does not require an external source of selenium vapour. The loss of a portion of the selenium during the heating is compensated for by an excess deposition of selenium on the metal stack. The selenium necessary for the selenization is provided by the deposited thin film of selenium.

In an alternative form, the selenization is obtained without the deposition of a thin film of selenium but by an atmosphere comprising gaseous selenium, for example based on Se or H₂Se, prior to the exposure to an atmosphere rich in sulphur.

As explained above, it can be advantageous to deposit a thin film based on alkali species, for example on sodium, for exact dosing of the sodium in the photoactive thin film.

Prior to the deposition of the CuGa and In metal stack, the alkali species are, for example, introduced by the deposition, on the sacrificial molybdenum-based thin film 12, of a thin film of sodium selenide or of a compound comprising sodium, so as to introduce, for example, of the order of 2 × 10¹⁵ sodium atoms per cm². The metal stack is deposited directly on this thin film of sodium selenide.

It should be noted that there exist numerous possible alternative forms for forming the CI(G)S or CZTS thin films, which alternative forms include, for example, the co-evaporation of the above mentioned elements, chemical vapour deposition, electrochemical deposition of metals, selenides or chalcopyrites, reactive sputtering of metals or selenides in the presence of H₂Se or H₂S.

Generally, the process for the manufacture of the photoactive thin film 22 is of any appropriate type.

All the processes for the manufacture of thin films of CIS or CZTS type use a stage of heating at high temperature in the presence of selenium and/or of sulphur in the vapour state or in the liquid state.

An important aspect of this invention is that the electrode can reach its final properties, like phase composition and resistivity, during the high temperature steps of solar cell process. Particularly the resistivity may drop advantageously to improve the solar cell efficiency.

### RESULTS AND EXPERIMENTS

The compatibility of different barriers to selenization thin films was analysed by a selenization test.

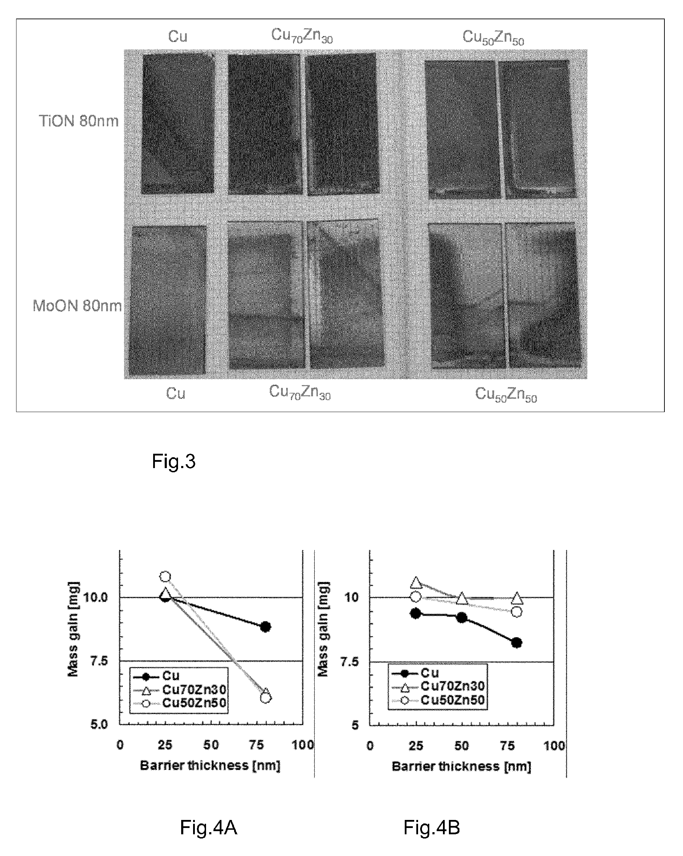

Fig.3 shows stacks of Glass/Cu or CuZn/Barrier/Mo were exposed to selenium vapour at 510°C during 10 minutes.

The thickness of the Cu or CuZn thin film was 200nm. The thickness of the barrier thin films of MoON or TiON was 80nm. The upper Mo thin film (usually 20-50nm) was always completely selenized.

If the selenization barrier fails, the metallic thin film below starts to corrode by forming selenides. The weight difference before and after the selenization test is a measure of the degree of selenization.

Fig.4A and 4B show mass gain for the same stacks as on Fig.3 but with different barrier thicknesses (25nm/50nm/80nm for TiON and 25nm/80nm for MoON).

While MoON was clearly more efficient when increasing the thickness, TiON was less efficient than MoON and did not clearly improve with barrier thickness.

Also, with MoON, CuZn alloys were clearly more resistant than Cu thin films..

In general the barrier thickness should be as low as possible for economic reasons: materials cost and machine time. As shown above for a given thickness the barrier properties are critical: 80nm TiON are much less efficient than 80nm MoON. Therefore the key is to find the barrier with the best properties so that the thickness can be reduced as much as acceptable with the solar cell device. Current results show that 40nm is a good compromise between selenization resistance and costs for MoON.

Other indicators for the degree of the selenization are the optical inspection from the glass side (see Fig.3) or the measurement of the resistivity after the selenization test (see Table II). The thin film stacks with the least selenization will show very small changes in resistivity. The starting values are usually in the range of 1 Ω/□ sheet resistance. Whereas thin films with optimized MoON barriers show no change in sheet resistance, thin films with TiON show a dramatic increase of resistivity above 100 Ohm/sq and more.

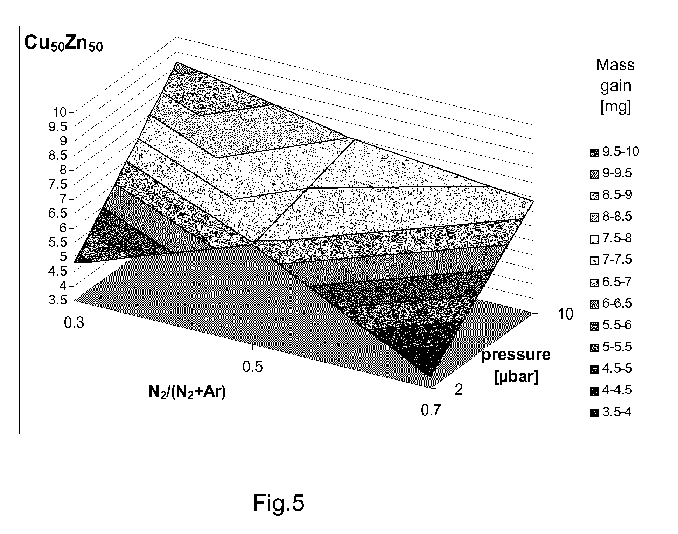

Table II and Fig. 5 shows that the barrier properties can be improved by using appropriate deposition parameters.

Table II shows results for stacks of
Glass/Cu50Zn50(200nm)/MoON(80nm)/Mo(30nm)

The thin films are deposited by magnetron sputtering from metal targets.

The ratio of N₂/(Ar+N₂) in the sputter gas and the total sputtering pressure were varied.

The barrier film properties were analyzed with respect to composition (Electron Microprobe analysis EPMA) and X-ray diffraction (XRD).

The stress was analyzed from thin glass bending analysis and XRD.

**Table II**

| Table I | Properties | | | | | |
|---|---|---|---|---|---|---|
| Pressure | 2µbar | | | 10µbar | | |
| N2/(N2+Ar) | 0.3 | 0.5 | 0.7 | 0.3 | 0.5 | 0.7 |
| Se-test mass gain [mg/50cm²] | 5 | 7 | 4 | 9 | 8 | 7 |
| Se-test Rₛₕ Ωsq | 18 | 6.7 | 1.0 | 745 | 152 | 57 |
| Stress | -250 MPa Compr. | -1900 MPa Compr. | -2700 MPa Compr. | >0 tensile | >0 tensile | >0 tensile |
| XRD grain size [nm] | 4.5 | 9.6 | 5.4 | 12.2 | 16.1 | 5.4 |
| EPMA composition | 4.26 | 1.78 | 1.0 | | | |

Table II shows that by varying the ratio of N₂/(Ar+N₂) in the sputter gas and the total sputtering pressure, the thin film properties can be controlled.

Low deposition pressure was found to be advantageous. This corresponds to a stack with compressive stress.

Low and high nitrogen ratio showed lower mass gain and thus selenization, which corresponds to small grain size.

A high nitrogen content was found to be advantageous in terms of resistivity of the back electrode after selenization.

Electron Probe Micro Analysis(EPMA) compositions ranged from 4.26 to 1.0, which corresponds to atomic content of N/(Mo+O+N) of 19% to 50% The EPMA value of 1.78 corresponds to 36% N/(Mo+O+N) atomic content.

Fig.5, 6A and 6B show selenization test results for different barrier deposition conditions.

The stacks were all
Glass/Cu50Zn50nm/MoON (80nm)/Mo(30nm)

The thin films are deposited by magnetron sputtering from metal targets.

The ratio of N₂/(Ar+N₂) in the sputter gas and the total sputtering pressure were varied.

In Fig.5 the ratio of N₂/N₂+Ar is varied between 0.3, 0.5 and 0.7. The pressure is either 2 or 10µbar.

In Fig.6A and 6B, the ratio of N₂/N₂+Ar was either 0.7 or 1. The pressure was either 1 or 2µbar.

The lowest degree of selenization is obtained by using low sputtering pressure, i.e. 1 or 2 µbar, and nitrogen ratio values N₂/(N₂+Ar) in the sputter gas of 70%-100%. Second best is N₂/(N₂+Ar)=0,3 with a pressure of 2µbar. As seen in Fig.6, the selenization barrier can further be improved by sputtering at low pressure and higher nitrogen.

In addition to TiON and MoON, also TaON was tested in Table II below.

Table II shows results for stacks of
Glass/Cu50Zn50(100nm)/TaON(80nm)/Mo(30nm)

The thin films are deposited by magnetron sputtering from metal targets.

The ratio of N₂/(Ar+N₂) in the sputter gas and the total sputtering pressure were varied.

**Table III**

| **Table III coated layer** | **N2 %** | **p** (µbar) | **Mass gain Se-test** (lg/5x10cm²) | **Sheet resistance before Se-test** (Ohm/sq) | **Sheet resistance after Se-test** (Ohm/sq) |
|---|---|---|---|---|---|
| 80 nm TaON | 15 | 3 | 9.7 | 0.63 | 15 |
| 80 nm TaON | 25 | 3.5 | 2.2 | 0.63 | 0.6 |
| 80 nm TaON | 40 | 3.5 | 2.4 | 0.59 | 0.6 |
| 80 nm TaON | 60 | 4 | 2.1 | 0.62 | 0.6 |

As Table III demonstrates, the thin film stacks with TaON also show good selenization behaviour. Apart from the deposition with 15% N₂ in the sputter gas N₂+Ar, all thin films show good stability. Moreover, XRD analysis also showed a very small crystallinity (2nm) and compressive stress. Measured values of film composition N/ (Ta+O+N) varied from 30% to 60%.

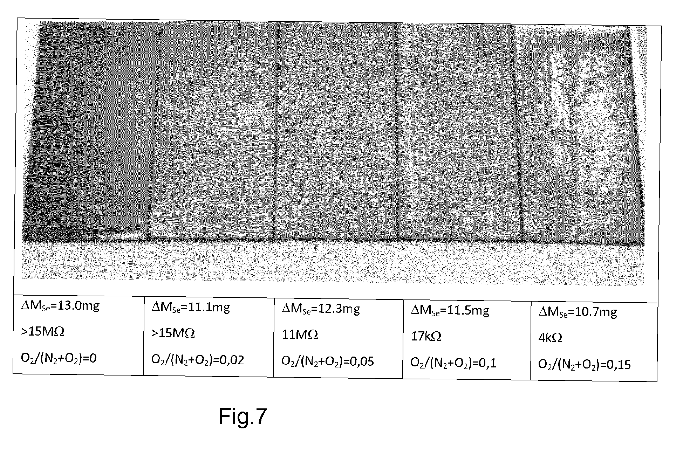

Fig.7 shows photographs of stacks of
Glass/Cu50Zn50(100nm)/MoON(20nm)/Mo(45nm) deposited with different oxygen ratio in the sputtering gas.

It should be noted that obtaining MoON with a low oxygen content may not require addition of oxygen as a sputtering gas and that it may be obtained with only residual oxygen. In all experiments described above and using MoON, TiON or TaON, addition of oxygen was usually not required even though oxynitrides were obtained.

The addition of oxygen lead to a visible improvement of the corrosion resistance. Whereas the MoON obtained without additional oxygen in the sputter gas showed a high mass gain and a high resistivity in the selenization test (Fig.7 left), the addition of 15% oxygen to the sputter gas lead to a significant reduction of resistivity and mass gain (Fig.7 right)

The backside still shows spots with the golden colour of the CuZn thin film. X-ray diffraction analysis indicated that by adding small amounts of oxygen to the sputter gas (O₂/(O₂+N₂)=0,1) the MoON thin films become amorphous.

The main technical problem to be solved was to find selenization barrier materials and deposition parameters that are compatible with selenization under high selenium and sulphur partial pressure (up to equilibrium vapor pressure at 500°C for selenium for metals that have a high affinity to sulphur and selenium (Cu, Ag, Aluminum).

The key was to develop a selenization and diffusion barrier that not only suppresses the diffusion of selenium into the metal thin film but also impedes the diffusion of metal atoms towards the selenium and the forming absorber. Retrospectively to the invention, it was found that prior art in the field of silicon microelectronics addresses this problem, but the physical chemistry of corrosion under selenium is far away from the problem of Cu diffusion into silicon in a silicon microelectronic device. Other effective Cu diffusion barriers like metal alloys (WMo) are not sufficient to withstand the reactive process atmosphere of the absorber formation process for chalcogenide thin film solar cells.

Our current understanding of the required film properties is that the compressive stress guarantees that the films are dense and remain coherent during thermal expansion. The nanocrystalline structure precludes columnar grain growth so that enhanced grain boundary diffusion is restricted. The refractory metals Mo, W, and Ta may have also an advantage compared to Ti in terms of restricted alloying with Cu. Due the chemical similarity also the other refractor metals Nb and Re are expected to form M'ON films that are efficient selenization and diffusion barriers.

As described above the barrier for selenization is particularly effective in the combination with main metallic thin films based on CuZn, AgZn and CuAgZn The barrier can also be combined with single metal films based on for example molybdenum (Mo), silver (Ag), or copper (Cu) with a content of at least 95% of on these metals. Alloying small amounts of other metals can have favorable effects on the mechanical properties which are relevant for the manufacturing of sputter targets and for the patterning processes for thin film chalcogenide solar cells. These single metal films will have an inferior corrosion resistance compared to the Cu and/or Ag alloys with Zn. They even more so require a very good selenization barrier which is the subject of this invention.

The selenization tests also revealed an additional important advantage of the barrier to selenization films made of MoON or TaON: after selenization the adhesion of the film stack was tested using a so-called tape test: a commercial polymer tape coated with a glue of specified adhesion force was glued to the full film stack on the selenized molybdenum thin film. By pulling at the tape manually perpendicular to the substrate plane a semi-quantitative measure of the mutual adhesion of the different layers can be obtained. The results were surprisingly clear: whereas in the case of TiON thin films the top MoSe₂ was easily removed from the TiON, the adhesion of the MoSSe₂ thin film to the MoON and TaON films was excellent. Also the complete stack including the alloy thin film and the barrier to alkali thin film strongly adhered to the glass substrate. With increasing force only the tape could be removed from the back electrode stack, i.e the adhesive strength of the glue was exceeded.

The following Table 3 shows several back electrode stacks that were tested for solar cells and modules. The thin film systems for the back electrode included in all cases a soda-lime-silica glass substrate (3mm), a Si₃N₄ alkali barrier thin film (140nm). The solar cells were produced in a two-step process: a precursor stack containing Cu, Ga, In, and Na was deposited by magnetron sputtering. A selenium thin film was deposited by thermal evaporation. The precursor stack was transformed into Cu(In,Ga)(S,Se)₂ using a rapid thermal process RTP in sulphur containing gas atmosphere. CdS was used as a buffer and ZnO:Al as the front electrode. Solar cells with 1,4cm² aperture area were produced by depositing a grid on top of the ZnO. Modules of size 10x10 or 30x30 cm² were manufactured with monolithic interconnection of 12 or 44 cells in series.

At first cells with glass/Si₃N₄/CuZn 100nm/TiON 13nm/Mo 35nm were processed. After the absorber formation process with temperatures above 500°C in the presence of selenium and sulphur the back electrode was partly corroded and the Cu(In,Ga)(S,Se)₂ absorbers showed partial lift-off during CdS deposition. After absorber formation the photo luminescence decay time was below 1ns on most positions, up to 54ns lifetime on single positions. All cells were completely shunted and showed no photovoltaic conversion efficiency. As seen above from the selenization test TiON does not work well for solar cells with CuZn base metal thin film. Table III (next page) shows that solar cells with CuZn base electrode and MoON or TaON as a selenization barrier with compressive stress and nanocrystalline or amorphous structure can reach high solar cells efficiencies.

Method for manufacturing a solar cell using the thin film stack is described above.

The thin film stack described in Fig. 1 will not be identical to the resulting stack in the solar cell in Fig.2.

The top Mo thin film will be intentionally transformed into a Mo(S,Se₂) thin film.

The alloy below the barrier may also change in phase composition. If the metals are deposited by magnetron sputtering or thermal evaporation, the temperature or plasma energy often are not sufficient to form the final alloy. During the formation of the solar cell higher temperatures are applied and the alloy that was initially intended will form.

**Table III**

| Table III | barrier sputter process | | Efficiency | | |
|---|---|---|---|---|---|
| Back electrode stack on glass/Si3N4 | Sputter Pressur e | Gasflow N₂/(Ar+N₂) | cells 1,4 cm2 | Modul e 10x10cm 2 | Modul e 30x30cm 2 |
| /CuZn 100nm/MoON 80nm/Mo 35nm | 2µbar | 30% | 13,0% | | |
| /Cu 50nm/Zn 50nm/Ti 20nm/MoON 80nm/Mo 35nm | 2µbar | 30% | 13,9% | 12,5% | |
| /Cu 50nm/Zn 50nm/Mo 20nm/MoON 80nm/Mo 35nm | 2µbar | 30% | 13,2% | | |
| /Cu 50nm/Zn 50nm/Mo 50nm/MoON 80nm/Mo 35nm | 2µbar | 30% | 12,8% | | |
| /CuZn 100nm/MoON 80nm/Mo 35nm | 1µbar | 70% | | 12,9% | |
| /CuZn 100nm/MoON 80nm/Mo 35nm | 1µbar | 100% | | 12,9% | |
| /CuZn 100nm/MoON 80nm/Mo 35nm | 2µbar | 70% | | 12,9% | |
| /CuZn 100nm/MoON 80nm/Mo 35nm | 2µbar | 30% | | 14,0% | |
| /CuZn 100nm/MoON 80nm/Mo 35nm | 2µbar | 70% | | 13,5% | |
| /Ti 2nm/CuZn 4DL 100nm/Mo 20nm/MoON 80nm/Mo 45nm | 2µbar | 70% | | | 12,7% |
| /Ti 2nm/CuZn 4DL 100nm/Mo 20nm/MoON 60nm/Mo 45nm | 2µbar | 70% | | | 13,2% |
| /Ti 2nm/CuZn 4DL 100nm/Mo 20nm/MoON 40nm/Mo 45nm | 2µbar | 70% | | | 13,3% |
| /Ti 2nm/CuZn 4DL 100nm/Mo 20nm/MoON 20nm/Mo 45nm | 2µbar | 70% | | | 12,3% |
| /Ti 2nm/CuZn 4DL 100nm/Mo 20nm/MoON 80nm/Mo 45nm | 2µbar | 70% | | | 12,7% |
| /Ti 2nm/CuZn 4DL 100nm/Mo 20nm/MoON 80nm/Mo 45nm | 2µbar | 30% | | | 13,2% |
| /Ti 2nm/CuZn 4DL 100nm/Mo 20nm/MoON 80nm/Mo 45nm | 2µbar | 100% | | | 13,1% |
| /Ti 2nm/CuZn 4DL 100nm/-/MoON 80nm/Mo 45nm | 2µbar | 70% | | 13,3% | 12,9% |
| /Ti 2nm/CuZn 4DL 100nm/Ta 20nm/TaON 80nm/Mo 45nm | 3.5µbar | 40% | | 13,5% | |

## Claims

1. Back contact substrate (1) for a photovoltaic cell, comprising a carrier substrate (2) and an electrode (6), the electrode (6) comprising:
- a conductive coating comprising a metallic thin film (8) based on a metal or metal alloy;
- a barrier to selenization thin film (10) for protecting the conductive coating and based on at least one among MoₓO_{y}N_{z}, WₓO_{y}N_{z}, TaₓO_{y}N_{z}, NbₓO_{y}N_{z}, ReₓO_{y}N_{z}.

2. Back contact substrate (1) according to claim 1, wherein the barrier to selenization thin film has a compressive stress between 0 and -10GPa, preferably between -1 and -5 GPa.

3. Back contact substrate (1) according to claim 1 or 2, wherein the barrier to selenization thin film is nano-crystalline or amorphous with a grain size of at most 10nm.

4. Back contact substrate (1) according to any preceding claim, wherein the barrier to selenization thin film has a molar composition O/(O+N) of at least 1% and at most 50%, preferably at least 2% and at most 20%.

5. Back contact substrate (1) according to any preceding claim, wherein the barrier to selenization thin film has a molar composition M'/(M'+O+N) of at least 15% and at most 80%.

6. Back contact substrate (1) according to any preceding claim, wherein the barrier to selenization thin film has a thickness of at least 5 nm and at most 100nm, preferably at least 10nm and at most 60nm.

7. Back contact substrate (1) according to any preceding claim, wherein the electrode comprises a second barrier to selenization thin film for protecting the conductive coating and based on at least one among MoₓO_{y}N_{z}, TiₓO_{y}N_{z}, WₓO_{y}N_{z}, TaₓO_{y}N_{z}, NbₓO_{y}N_{z}, ReₓO_{y}N_{z}.

8. Back contact substrate (1) according to any preceding claim, wherein said electrode (6) further comprises an interlayer thin film between the conductive coating and the barrier to selenization thin film, the interlayer thin film being based on at least one of titanium (Ti), tungsten (W), molybdenum (Mo), rhenium (Re), niobium (Nb) or tantalum (Ta).

9. Back contact substrate (1) according to any preceding claim, wherein said electrode (6) further comprises an ohmic contact thin film based on at least a metal M, preferably based on molybdenum (Mo) and/or tungsten(W).

10. Back contact substrate (1) according to any preceding claim, wherein the metallic thin film (8) is an alloy thin film based on at least two elements, at least one first element M_{A} chosen among copper (Cu), silver (Ag) and gold (Au), and at least one second element M_{B} chosen among zinc (Zn), titanium (Ti), tin (Sn), silicon (Si), germanium (Ge), zirconium (Zr), hafnium (Hf), carbon (C) and lead (Pb).

11. Back contact substrate (1) according to the preceding claim, wherein the main metallic thin film (8) is based on:
● at least one of copper (Cu) and silver (Ag); and
● on zinc (Zn).

12. Back contact substrate (1) according to any preceding claim, wherein the metallic thin film is based on:
● at least one of copper (Cu) and silver (Ag); and
● on zinc (Zn) and titanium (Ti).

13. Photovoltaic cell (30) comprising a back contact substrate (1) according to any preceding claim and at least a thin film of a photoactive material.

14. Process for the manufacture of a back contact substrate (1) for a photovoltaic cell (30), comprising a step of making an electrode (6) comprising steps of making:
- a conductive coating comprising a metallic thin film (8) based on a metal or metal alloy;
- a barrier to selenization thin film (10) for protecting the conductive coating and based on at least one among MoₓO_{y}N_{z}, WₓO_{y}N_{z}, TaₓO_{y}N_{z}, NbₓO_{y}N_{z}, ReₓO_{y}N_{z}.

15. Process according to claim 14, comprising a step of formation of a photoactive thin film during which resistivity of the electrode is decreased, and the obtained sheet resistance after thermal annealing is below 2 Ω/□, preferably below 1 Ω/□.
